# EUROPEAN PATENT APPLICATION

(11) **EP 2 634 916 A1**
(43) Date of publication of application: **04.09.2013**
(21) Application number: 12360011.6
(22) Date of filing: 29.02.2012
(51) Int. Cl.: H03F 1/02, H03F 1/48, H03F 1/56

(54) **Doherty amplifier**

(71) Applicant: Alcatel Lucent, 75007 Paris (FR)
(72) Inventor: Grebennikov, Andrei, Castleknock Dublin 15 (IE); Wong, James N.H., London, W3 0HW (GB)
(74) Representative: Script IP Limited

(57) **Abstract**

A Doherty amplifier (10) is operable to receive an input signal (Pin) and to provide an amplified output signal (Pout) at an amplifier output (95). The Doherty amplifier (10) comprises: first (30) and second (40) amplifier stages, each amplifier stage being switchable between an amplifying and a non-amplifying state, each amplifier stage being arranged in parallel to receive the input signal (Pin) and, in the amplifying state, to provide a respective amplified signal at a respective amplifier stage output; and an output network (50) comprising first (80) and second (90) impedance transformers, each impedance transformer being coupled at a first side with a respective amplifier stage output and being coupled together in parallel at a second side with the amplifier output (95). By using an alternative, parallel architecture, the impedance transformation ratio experienced by an amplified signal under different operating conditions is significantly reduced compared to that of a traditional architecture which uses a single, series, impedance transformer which combines and transforms the amplified signals from both amplifier stages (30, 40).

## Description

### FIELD OF THE INVENTION

The present invention relates to a Doherty amplifier.

### BACKGROUND

Doherty amplifiers are known. In most communications systems, it is required that power amplifiers used to amplify signals for transmission are able to operate with high efficiency and high linearity simultaneously. However, there is typically a trade-off between efficiency and linearity, with improvements in one generally coming at the expense of the other. Many wireless telecommunications systems, such as Global System for Mobile Communications (GSM)/Enhanced Data Rates for GSM Evolution (EDGE), Code division multiple access (CDMA 2000) or Wideband Code Division Multiple Access (WCDMA) require that the power amplifier is able to deliver a wide range of output powers. Accordingly, the power amplifiers are typically designed to provide the highest power output level with the maximum available efficiency. These amplifiers, which may be provided in base stations, tend to operate less efficiently at lower power output levels since they consume comparatively high amounts of direct current (DC) power at these lower power output levels. Designing a base station power amplifier which has a high efficiency and high linearity, not only at the maximum output power, but also at lower output power levels, typically ranging from -6DB and less, without using additional linearisation schemes is challenging. A Doherty power amplifier is one such parallel amplifier in which a carrier amplifier is provided in parallel with a peaking amplifier. The input signal is split and provided to each of the two amplifiers. Both of the amplifiers then amplify the signal, which is then combined to create an output signal. When operating at the maximum power output, both amplifiers are utilised. However, when the total output power is typically less than 6dB from the maximum output power, the peaking amplifier is turned off. This arrangement provides higher efficiency compared to conventional class AB solutions since the carrier 30 amplifier is biased in class AB, but the peaking amplifier is biased in class C and is turned off when the total output power is typically less than 6dB from the maximum output power level.

Although these arrangements provide for high efficiency at other than the maximum output power level, such Doherty amplifiers exhibit undesirable characteristics.

Accordingly, it is desired to provide an improved Doherty amplifier.

### SUMMARY

According to a first aspect, there is provided a Doherty amplifier operable to receive an input signal and to provide an amplified output signal at an amplifier output, the Doherty amplifier comprising: first and second amplifier stages, each amplifier stage being switchable between an amplifying and a non-amplifying state, each amplifier stage being arranged in parallel to receive the input signal and, in the amplifying state, to provide a respective amplified signal at a respective amplifier stage output; and an output network comprising first and second impedance transformers, each impedance transformer being coupled at a first side with a respective amplifier stage output and being coupled together in parallel at a second side with the amplifier output.

The first aspect recognises that a problem with existing Doherty architectures is that the bandwidth of the amplifier, particularly in a low power region where one of the amplifier stages is switched off, becomes restricted. This significantly reduces the performance of the Doherty amplifier and reduces its utility to operate across a wide frequency band in order to support communications using different frequencies. In particular, the first aspect recognises that a major influence which constrains the bandwidth of the Doherty amplifier in the low power region is the maximum impedance transformation ratio within the output network which is experienced by the amplified signal being provided by the Doherty amplifier.

The first aspect recognises, therefore, that by changing the architecture of the output network, it is possible to reduce the maximum impedance transformation ratio being experienced by the amplified signal, particularly when one of the amplifier stages is switched off. Reducing this maximum transformation ratio leads to an improved loaded quality factor which, in turn, results in broader bandwidth performance.

Accordingly, a parallel amplifier, such as a Doherty amplifier, is provided. The amplifier may receive an input signal and may provide an amplified output signal. The amplifier may comprise a first amplifier stage and a second amplifier stage. Each amplifier stage may be switchable between an amplifying state and a non-amplifying state. Each amplifier stage may be arranged in parallel to receive the input signal. When in the amplifying state, each amplifier stage may provide a respective amplified signal at its amplifier stage output. An output network may be provided between the first and second amplifier stages and the amplifier output. The output network may comprise first and second impedance transformers. One side of each impedance transformer may be coupled with a respective amplifier stage output. The other side of each impedance transformer may be coupled together in parallel with the amplifier's output.

By using an alternative, parallel architecture, the impedance transformation ratio experienced by an amplified signal under different operating conditions is significantly reduced compared to that of a traditional architecture which uses a single, series, impedance transformer which combines and transforms the amplified signals from both amplifier stages. By reducing the maximum impedance transformation ratio experienced by the amplified signal, loaded quality factor is significantly improved which in turn improves the operating bandwidth of the amplifier.

In one embodiment, both the first and second impedance transformers present an input impedance to the respective amplifier stage output which matches an output impedance of the first and second amplifier stages when the first and second amplifier stages are in the amplifying state. Accordingly, the impedance transformers may be impedance matched when in their amplifying state.

In one embodiment, at least one of the first and second impedance transformers provide a maximum ratio of impedances presented at an associated first side and second side which remains constant irrespective of an amplifying state of each amplifier stage. Accordingly, the maximum ratio of impedances remains unchanged which helps to maintain the loaded quality factor and maintain the bandwidth of the amplifier under different operating conditions.

In one embodiment, at least one of the first and second impedance transformers provide an impedance transformation ratio between an impedance presented at the first side and an impedance presented at the second side which is unchanged in response to changes in an amplifying state of an associated amplifier stage.

In one embodiment, the first and second impedance transformers together present a parallel impedance characteristic equivalent to a series impedance characteristic between the amplifier stage outputs and the amplifier output when the first and second amplifier stages are in the amplifying state.

In one embodiment, the impedance transformation ratio is around 2:1.

In one embodiment, the first and second impedance transformers comprise quarter wave transformers.

In one embodiment, the first amplifier stage comprises a carrier stage and the second amplifier stage comprises a peaking stage.

In one embodiment, the amplifier comprises a first phase shifter operable to shift a phase of the input signal provided to the carrier stage.

In one embodiment, the amplifier comprises a second phase shifter operable to shift a phase of the amplified signal provided from the peaking stage to the second impedance transformer.

In one embodiment, the first and second phase shifters comprise quarter wave transformers.

In one embodiment, the first phase shifters has a characteristic impedance matching an input impedance of the first stage and second phase shifter has a characteristic impedance matching an output impedance of the second stage.

In one embodiment, the amplifier comprises a plurality of amplifier stages and a corresponding plurality of impedance transformers each being connected at a first side with a respective amplifier stage output and being coupled together in parallel at a second side with the amplifier output.

Further particular and preferred aspects of the present invention are set out in the accompanying independent and dependent claims. Features of the dependent claims may be combined with features of the independent claims as appropriate, and in combinations other than those explicitly set out in the claims.

Where an apparatus feature is described as being operable to provide a function, it will be appreciated that this includes an apparatus feature which provides that function or which is adapted or configured to provide that function.

### BRIEF DESCRIPTION OF THE DRAWINGS

The present invention will be described further, by way of example only, with reference to preferred embodiments thereof as illustrated in the accompanying drawings, in which:
Figure 1 illustrates an example two-way Doherty amplifier according to one embodiment;
Figure 2 illustrates the arrangement of a classical Doherty amplifier;
Figure 3a shows the effective impedances of the embodiment shown in Figure 1 when the peaking amplifier is switched off and so is in the non-amplifying state;
Figure 3b shows the effective impedances of the arrangement of Figure 2 when the peaking amplifier is switched off and so is in the non-amplifying state;
Figure 3c shows the bandwidth of the embodiment shown in Figure 1 against the arrangement of Figure 2;
Figure 4 illustrates an example two-way Doherty amplifier according to another embodiment; and
Figure 5 illustrates an example two-way Doherty amplifier according to a yet further embodiment.

### DESCRIPTION OF THE EMBODIMENTS

### Overview

Before discussing embodiments in any detail, first an overview will be provided. As mentioned above, classical two-way Doherty amplifiers have limited bandwidth capability in the low power region, since in a typical 50 Ohms implementation it becomes necessary to provide an impedance transformation from 25 Ohms to 100 Ohms when the peaking amplifier is turned off. This results in a loaded quality factor of QL = sqrt((100/25)-1) = 1.73 at a 3 dB output power reduction level which is sufficiently high for broadband operation.

However, embodiments provide a modified parallel architecture for two-way Doherty amplifier. This architecture utilises a modified modulated load network which improves bandwidth properties in the low power region by reducing the impedance transformation ratio compared to the classical approach by a factor of 2. This improves the loaded quality factor and results in an associated increase in bandwidth.

In general, this reduced transformation ratio is achieved by effectively replacing a single impedance transformer which would normally be placed in series between a combining node which receives amplified signals from both the carrier and peaking amplifier stages and the amplifier output. The replacement for this single series impedance transformer is a parallel arrangement of two impedance transformers which presents the equivalent characteristic impedance as the single series impedance transformer. This has the effect of reducing the maximum impedance transformation ratio when the peaking amplifier is switched off, which in turn improves the loaded quality factor and increases the bandwidth of the amplifier, as will be explained in more detail below.

### First Embodiment

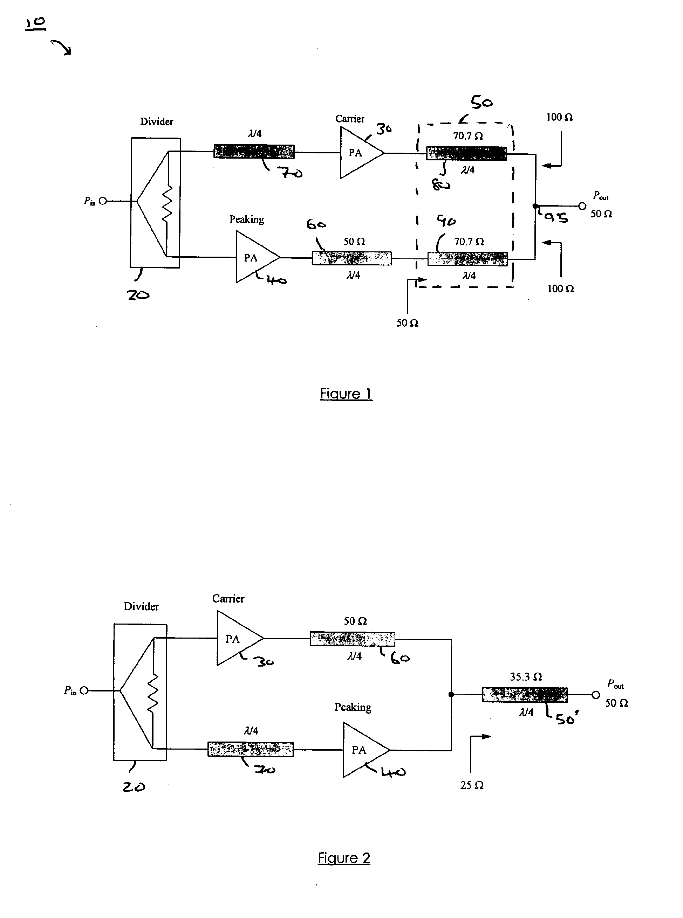

Figure 1 illustrates an example two-way Doherty amplifier, generally 10, according to one embodiment. An input signal Pin is provided to a divider 20. The divider 20 splits the input signal and provides it over a path to both a carrier amplifier 30 and a peaking amplifier 40.

The signal provided to the carrier amplifier 30 first passes through a quarter wavelength transmission line 70 which provides a 90° phase shift of the input signal prior to this being received by the carrier amplifier 30. The carrier amplifier 30 then outputs the amplified signal to an output network 50.

The peaking amplifier 40 receives the input signal and also outputs this to the output network 50. However, a quarter wave transmission line 60 receives the amplified signal output by the peaking amplifier 40 and performs a 90° phase shift in the same manner as the quarter wave transmission line 70 prior to the amplified signal being provided to the output network 50.

The output network 50 comprises a pair of transmission lines 80, 90. A first transmission line 80 is coupled at a first side with the output of the carrier amplifier 30. A second transmission line 90 is coupled at a first side with the output from the quarter wave transmission line 60. The second side of the first transmission line 80 and the second side of the second transmission line 90 are coupled together at a combining node 95 to provide an output signal Pout.

Referring to Figure 2, which shows the arrangement of a classical Doherty amplifier, in order to ensure correct operation of this example amplifier which has an input and output impedance of 50 Ohms, the quarter wave impedance transformer 50' is calculated to have a characteristic impedance of 35.3 Ohms. Also, as can be seen in Figure 2, the peaking amplifier 40 is coupled at its input with the transmission line 70 to receive 90° phase shifted input signal to be amplified whilst the carrier amplifier 30 is coupled with the quarter wave transmission line 60 at its output. Hence, it can be seen that the role of the peaking amplifier and the carrier amplifier is effectively swapped between the classical Doherty amplifier and the embodiment shown in Figure 1.

Referring back to Figure 1, the characteristic impedance of the first and second transmission lines 80, 90 is selected to present the same characteristic impedance. Hence, in this example, the characteristic impedance of the first and second transmission lines 80, 90 is calculated to be 70.7 Ohms.

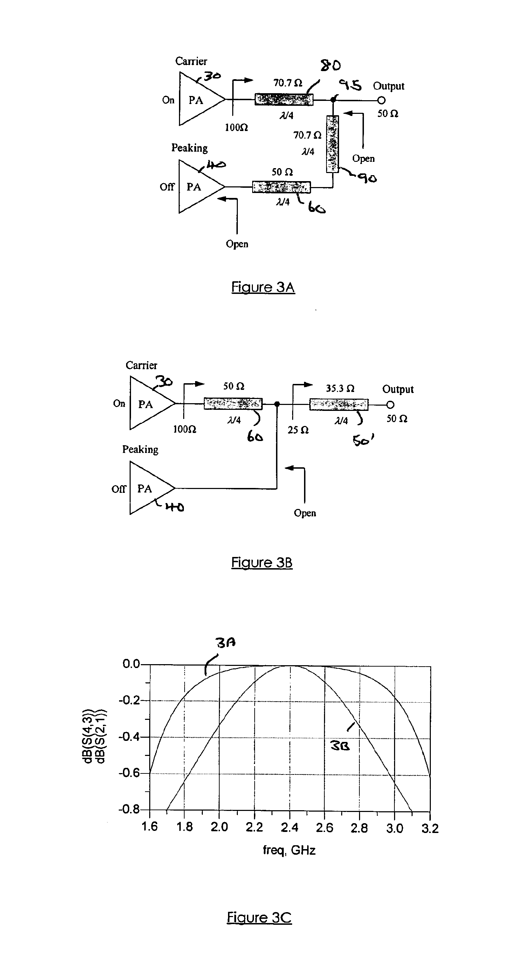

Figure 3a shows the effective impedances of the embodiment shown in Figure 1 when the peaking amplifier 40 is switched off and so is in the non-amplifying state. With the peaking amplifier 40 off, this presents an open circuit to the transmission line 60. This then results in a short circuit being presented to the second transmission line 90. This causes an open circuit to be presented to the summing point 95. Hence, when in the non-amplifying state, the peaking amplifier 40 is effectively decoupled.

The output impedance of 50 Ohms presented to the first impedance transformer 80 is then transformed by the first impedance transformer 80 to present 100 Ohms to the carrier amplifier 30.

It can be seen that the maximum impedance transformation ratio experienced by a signal being amplified by the Doherty amplifier 10 when the peaking amplifier 40 is switched off is 100 Ohms /50 Ohms = 2; that is the ratio of the impedance on one side of the first impedance transformer 80 compared to the impedance on the other side of the first impedance transformer 80.

This should be compared to the impedances experienced in the classical arrangement shown in Figure 3b where, when the peaking amplifier 40 is switched off, an impedance transformation ratio of 100 Ohms /25 Ohms = 4 is experienced.

As can be seen in Figure 3c, this reduced maximum impedance transformation ratio alters the loaded quality factor provides for a significantly wider operating bandwidth.

### Second Embodiment

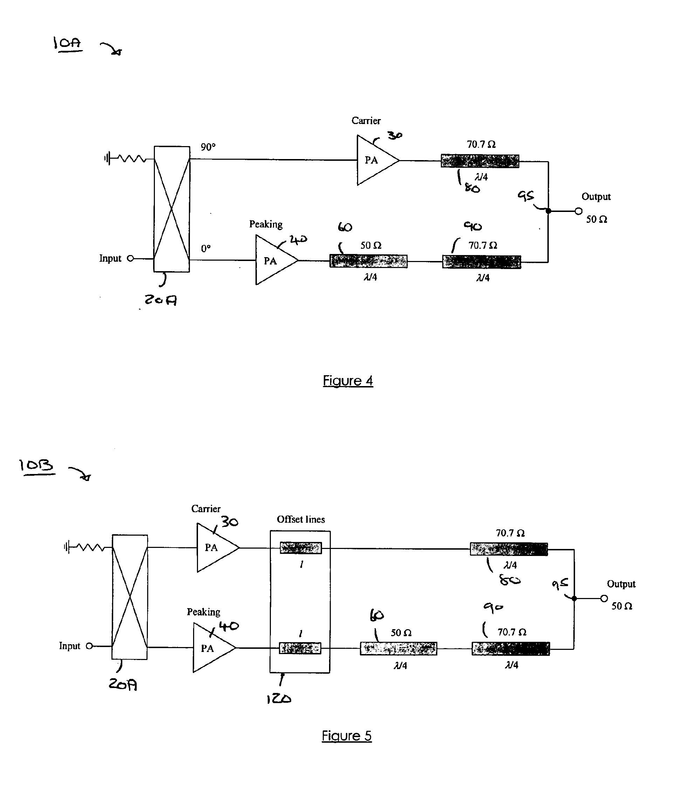

Figure 4 illustrates a second embodiment of the two-way Doherty amplifier 10a which utilises a hybrid coupler 20a which outputs an in-phase and a 90° out phase signal and thus obviates the need to provide the transmission line 70 described above. Otherwise, the configuration and operation of the amplifier is the same as the first embodiment mentioned above.

### Third Embodiment

Figure 5 illustrates a third embodiment of a two-way Doherty amplifier 10b which utilises a pair of variable length transmission lines or offset lines 120 which help compensate for parasitic characteristics of the peaking amplifier 40 and the carrier amplifier 30. Otherwise, the configuration and operation of the amplifier is the same as the second embodiment mentioned above.

Hence, it can be seen that in the proposed parallel architectures of the two-way Doherty amplifier of the embodiments mentioned above with reference to Figures 1, 4 and 5, the output load network for the carrier amplifier consists of a single quarter wave transmission line required for impedance transformation, the output load network for the peaking amplifier consists of a 50 Ohm quarter wave transmission line followed by another quarter wave line required for impedance transformation, and a quarter wave transmission line at the input of the carrier amplifier is necessary for phase compensation. In these embodiments, both impedance-transforming quarter wave lines have a characteristic impedance of 70.7 Ohms and each provide impedance transformation from 100 Ohm at their outputs, resulting in a 50 Ohm load by their parallel connection, and a 50 Ohm impedance seen by each amplifier output in the high power region between maximum power and a power backoff of -6 dB.

In the classical arrangement shown in Figure 2, in the low power region, when the peaking amplifier is turned off, the required impedance of 100 Ohm seen by the carrier amplifier output is achieved by the quarter wave line with a characteristic impedance of 35.3 Ohm transforming a 50 Ohm load to 25 Ohm and then a 50 Ohm quarter wave line transforms the intermediate 25 Ohm to the required 100 Ohm, as shown in Figure 3B. In this case, the maximum impedance-transforming ratio is 100/25 = 4.

In contrast, as can be seen in Figure 3A, the parallel Doherty configuration shown in Figures 1, 4 and 5 provides an impedance transformation with a maximum impedance-transforming ratio of 100/50 = 2 using the single quarter wave line with a characteristic impedance of 70.7 Ohm, as shown in Figure 3A from 50 Ohm load to 100 Ohm seen by the carrier amplifier output, which is two times smaller than the maximum impedance-transforming ratio of the arrangement shown in Figure 2.

This provides a loaded quality factor of only QL = sqrt(100/50 - 1) = 1 which results in 1.73 times broader frequency range, as shown in Figure 3C by the curve 3A with a central bandwidth frequency of 2.4 GHz compared with the curve 3B for the classical arrangement.

Since the output load network of the peaking amplifier contains two quarter wave transmission lines connected in series, this provides an overall half-wave length, and an open circuit at the peaking amplifier output directly transforms to the load.

As mentioned above, Figure 4 shows a parallel Doherty configuration with a 90-degree input coupler according to a second embodiment, whereas Figure 5 shows an third embodiment using offset lines in each amplifying path to compensate for the parasitic output reactance of the carrier amplifier caused by the transistor and output matching circuit.

Generally, transmission lines can be replaced by equivalent lumped-element structures. If necessary, the input offset line can be used at the input of peaking amplifier since it is biased in Class C.

Accordingly, it can be seen that arrangements are provided which enable highly efficient operation of, for example, a base station power amplifier at maximum and back-off output power levels across a wide frequency bandwidth.

A person of skill in the art would readily recognise that steps of various above-described methods can be performed by programmed computers. Herein, some embodiments are also intended to cover program storage devices, e.g., digital data storage media, which are machine or computer readable and encode machine-executable or computer-executable programs of instructions, wherein said instructions perform some or all of the steps of said above-described methods. The program storage devices may be, e.g., digital memories, magnetic storage media such as a magnetic disks and magnetic tapes, hard drives, or optically readable digital data storage media. The embodiments are also intended to cover computers programmed to perform said steps of the above-described methods.

The functions of the various elements shown in the Figures, including any functional blocks labelled as "processors" or "logic", may be provided through the use of dedicated hardware as well as hardware capable of executing software in association with appropriate software. When provided by a processor, the functions may be provided by a single dedicated processor, by a single shared processor, or by a plurality of individual processors, some of which may be shared. Moreover, explicit use of the term "processor" or "controller" or "logic" should not be construed to refer exclusively to hardware capable of executing software, and may implicitly include, without limitation, digital signal processor (DSP) hardware, network processor, application specific integrated circuit (ASIC), field programmable gate array (FPGA), read only memory (ROM) for storing software, random access memory (RAM), and non volatile storage. Other hardware, conventional and/or custom, may also be included. Similarly, any switches shown in the Figures are conceptual only. Their function may be carried out through the operation of program logic, through dedicated logic, through the interaction of program control and dedicated logic, or even manually, the particular technique being selectable by the implementer as more specifically understood from the context.

It should be appreciated by those skilled in the art that any block diagrams herein represent conceptual views of illustrative circuitry embodying the principles of the invention. Similarly, it will be appreciated that any flow charts, flow diagrams, state transition diagrams, pseudo code, and the like represent various processes which may be substantially represented in computer readable medium and so executed by a computer or processor, whether or not such computer or processor is explicitly shown.

The description and drawings merely illustrate the principles of the invention. It will thus be appreciated that those skilled in the art will be able to devise various arrangements that, although not explicitly described or shown herein, embody the principles of the invention and are included within its spirit and scope. Furthermore, all examples recited herein are principally intended expressly to be only for pedagogical purposes to aid the reader in understanding the principles of the invention and the concepts contributed by the inventor(s) to furthering the art, and are to be construed as being without limitation to such specifically recited examples and conditions. Moreover, all statements herein reciting principles, aspects, and embodiments of the invention, as well as specific examples thereof, are intended to encompass equivalents thereof.

## Claims

1. A Doherty amplifier operable to receive an input signal and to provide an amplified output signal at an amplifier output, said Doherty amplifier comprising:
first and second amplifier stages, each amplifier stage being switchable between an amplifying and a non-amplifying state, each amplifier stage being arranged in parallel to receive said input signal and, in said amplifying state, to provide a respective amplified signal at a respective amplifier stage output; and
an output network comprising first and second impedance transformers, each impedance transformer being coupled at a first side with a respective amplifier stage output and being coupled together in parallel at a second side with said amplifier output.

2. The Doherty amplifier of claim 1, wherein both said first and second impedance transformers present an input impedance to said respective amplifier stage output which matches an output impedance of said first and second amplifier stages when said first and second amplifier stages are in said amplifying state.

3. The Doherty amplifier of claim 1 or 2, wherein at least one of said first and second impedance transformers provide a maximum ratio of impedances presented at an associated first side and second side which remains constant irrespective of an amplifying state of each amplifier stage.

4. The Doherty amplifier of any preceding claim, wherein at least one of said first and second impedance transformers provide an impedance transformation ratio between an impedance presented at said first side and an impedance presented at said second side which is unchanged in response to changes in an amplifying state of an associated amplifier stage.

5. The Doherty amplifier of any preceding claim, wherein said first and second impedance transformers together present a parallel impedance characteristic equivalent to a series impedance characteristic between said amplifier stage outputs and said amplifier output when said first and second amplifier stages are in the amplifying state.

6. The Doherty amplifier of any one of claims 3 to 5, wherein said impedance transformation ratio is 2:1.

7. The Doherty amplifier of any preceding claim, wherein said first and second impedance transformers comprise quarter wave transformers.

8. The Doherty amplifier of any preceding claim, wherein said first amplifier stage comprises a carrier stage and said second amplifier stage comprises a peaking stage.

9. The Doherty amplifier of any preceding claim, comprising a first phase shifter operable to shift a phase of said input signal provided to said carrier stage.

10. The Doherty amplifier of any preceding claim, comprising a second phase shifter operable to shift a phase of said amplified signal provided from said peaking stage to said second impedance transformer.

11. The Doherty amplifier of claims 9 or 10, wherein said first and second phase shifters comprise quarter wave transformers.

12. The Doherty amplifier of any one of claims 9 to 11, wherein said first phase shifter has a characteristic impedance matching an input impedance of said first stage and second phase shifter has a characteristic impedance matching an output impedance of said second stage.

13. The Doherty amplifier of any preceding claim, comprising a plurality of amplifier stages and a corresponding plurality of impedance transformers each being connected at a first side with a respective amplifier stage output and being coupled together in parallel at a second side with said amplifier output.
